# EUROPEAN PATENT SPECIFICATION

(11) **EP 0 694 844 B1**
(45) Date of publication and mention of the grant of the patent: **15.09.1999**
(21) Application number: 95111550.0
(22) Date of filing: 22.07.1995
(51) Int. Cl.: G06F 12/08

(54) **Reduced memory pin addressing for cache and main memory**
Addressierung mit einer niedrigen Anzahl von Speicherstiften für Cache- und Haupt-Speicher
Adressage à faible nombre de broches de mémoire pour une antémémoire et une mémoire principale

(30) Priority: 28.07.1994 US 281832
(43) Date of publication of application: 31.01.1996
(73) Proprietor: SUN MICROSYSTEMS, INC., Mountain View, CA 94043 (US)
(72) Inventor: Young, Mark S., Mountain View, CA. 94040 (US); Lenoski, Daniel E., San Jose, CA. 95129 (US)
(74) Representative: Sparing - Röhl - Henseler Patentanwälte

(56) References cited:
- EP-A- 0 468 786
- WO-A-92/12484
- PATENT ABSTRACTS OF JAPAN vol. 17, no. 381 (P-1574) 16 July 1993 & JP-A-05 061 769 (DAIKIND IND) 12 March 1993

## Description

The invention concerns a method for operating a computer system according to the preamble of claim 1 and a computer system according to the preamble of claim 8.

Such a method and computer system are known from Abstract of JP-A-5061769 according to which row and column address bits are provided simultaneously so that the address bus for transmitting these bits necessarily has a number of pins according to the total number of address bits required to fully access main memory.

In high performance computers, high speed cache memory typically formed of high speed static random access memory (SRAM) is often used in order to store recently used information or information which is likely to be repeatedly used, in order to increase the speed of the overall memory accesses. In such high performance computers which utilize cache memory, it is important to provide address information from the processor to the cache and main memory as quickly as possible. This is especially true in cases where there is first or second level external cache, i.e. which is located external to the CPU or microprocessor. In the prior art, processors send the entire address (up to 32 bits in current machines) out to form an index into the cache data and tag RAMs. With the full address, the cache and main memory cycles can be started concurrently if desired, with desired information being returned from cache memory if the desired information is currently stored in cache memory (a "cache hit"), or from the main memory in the event that the desired information is not currently stored in the cache memory (a "cache miss"). Unfortunately, integrated circuit pins and in some cases the number of paths forming busses are scarce resources on the highly integrated processors and systems being built today. Minimization of the address pins assists designers in up to four ways:
1) reduced pin count saves on package size and integrated circuit die size;
2) fewer address signals switching simultaneously reduces the instantaneous current surge caused by switching many address lines, thereby reducing "ground bounce";
3) reduced burden of the hidden cost of signal pins, i.e., reduction in added power and ground pins required for larger numbers of signal pins; and
4) in some implementations a reduced overall power dissipation by reducing the number of address transitions at the signal I/Os on the integrated circuit.

An additional future benefit is due to the growth of the address range of modern computers. Most computers today operate with up to 32 bits of physical address. However, the next generation of machines is pushing up the address range to 64 bits. Hence, the pressure to use even more pins is reduced when techniques are used in order to minimize the number of address pins required.

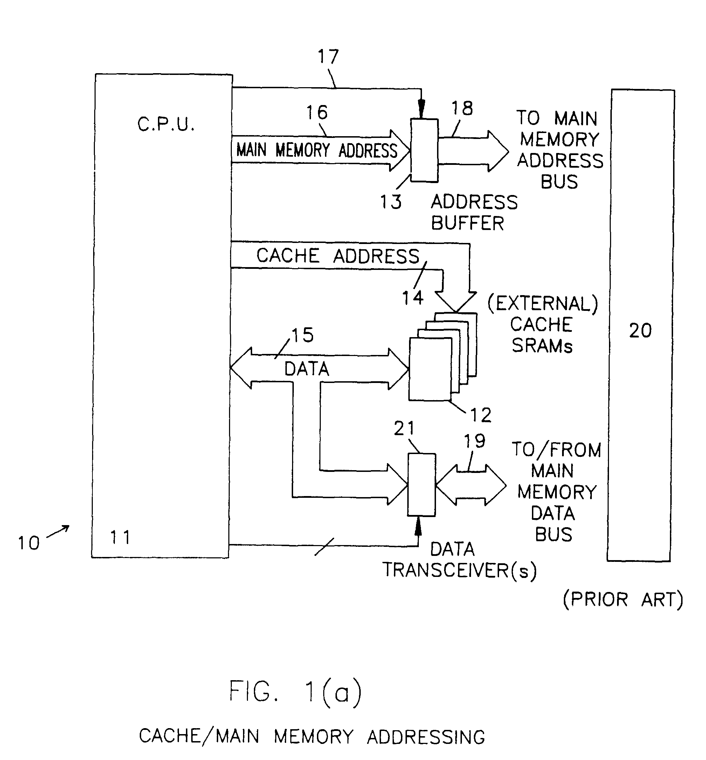

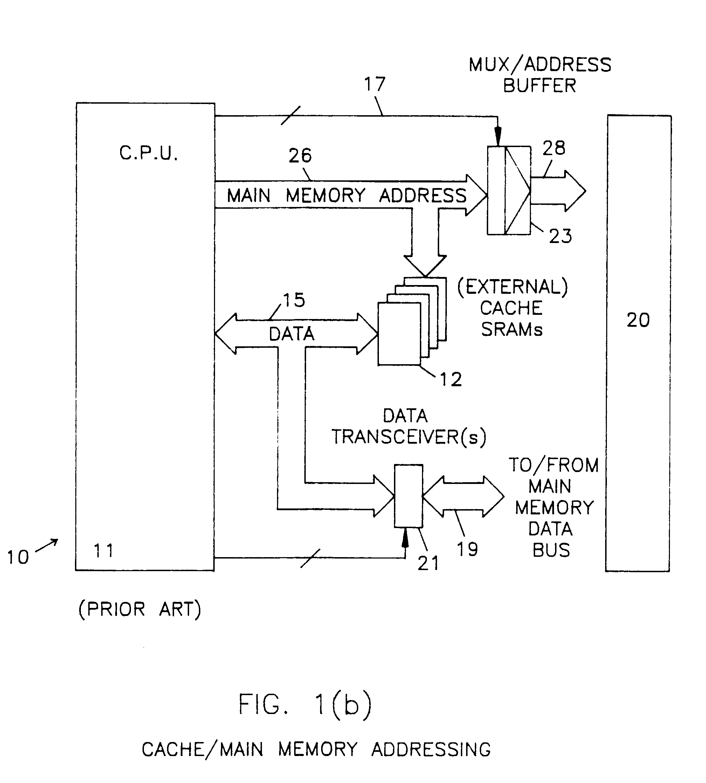

It is known in the prior art to generate the necessary addressing for a computer system from the CPU while utilizing fewer address pins than the total number of address bits. Figures 1a and 1b illustrate two prior art techniques for accomplishing this result.

Figure 1a is a block diagram of a typical prior art computer system 10, or a portion thereof including CPU 11, main memory 20 including a main memory controller, cache memory 12 including a cache memory controller, and appropriate busses and control lines located between CPU 11 and main memory 20 and cache memory 12, such as main memory address bus 16/18, address buffer for registered address buffer 13, registered address buffer latch control line 17, cache memory address bus 14, main memory data bus 19, data transceiver 21, and data bus 15. Prior art Figure 1a shows a CPU with separate cache address and main memory address busses 14 and 16/18, respectively. A CPU designer would only provide cache address pins on CPU 11 if the CPU designer knew in advance that cache memory 12 was external to CPU 11.

Figure 1b is a diagram depicting an alternative prior art structure including CPU 11, cache memory 12, and main memory 20. In the prior art circuit of Figure 1b, CPU 11 provides the full address on address bus 26 and lets the controller circuits of external cache memory 12 and main memory 20 steer and latch it as required in order to properly address cache memory 12 and main memory 20, respectively. In the prior art circuit of Figure 1b, the full address is brought out simply to provide external memory interface 23 with the necessary information to address main memory 20. In the prior art circuit of Figure 1b, cache memory 12 can be included whether or not the CPU even knows about its existence, since there are no CPU pins dedicated solely for addressing cache memory 12. Hence, the minimal address provided by CPU 11 is limited by the amount of physical memory to be addressed by the CPU 11. This may not even be the full address range capable by the CPU 11, though if it is less than such a range, it is typical to save the pins and cut chip costs even though internally CPU 11 can address a larger range. An example of this is the Motorola 68000 CPU, which is designed to address up to 32 bits of address, but was put into packages that only provide 24 bits of address to save pins and cost.

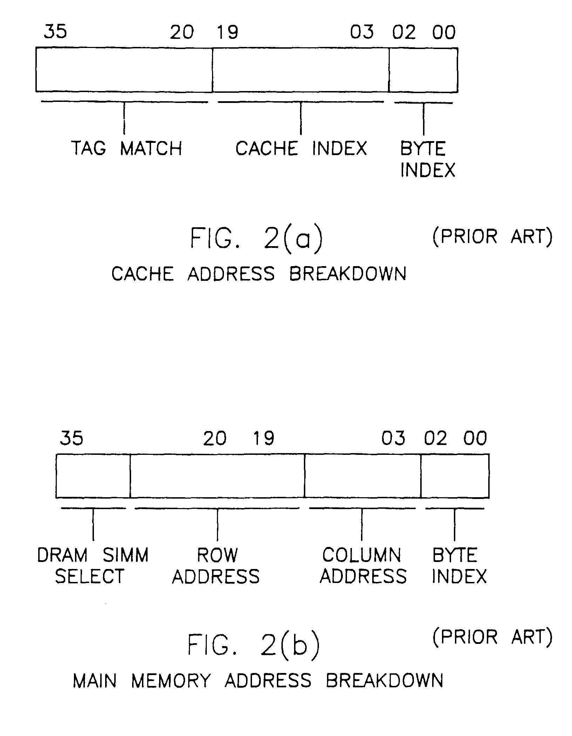

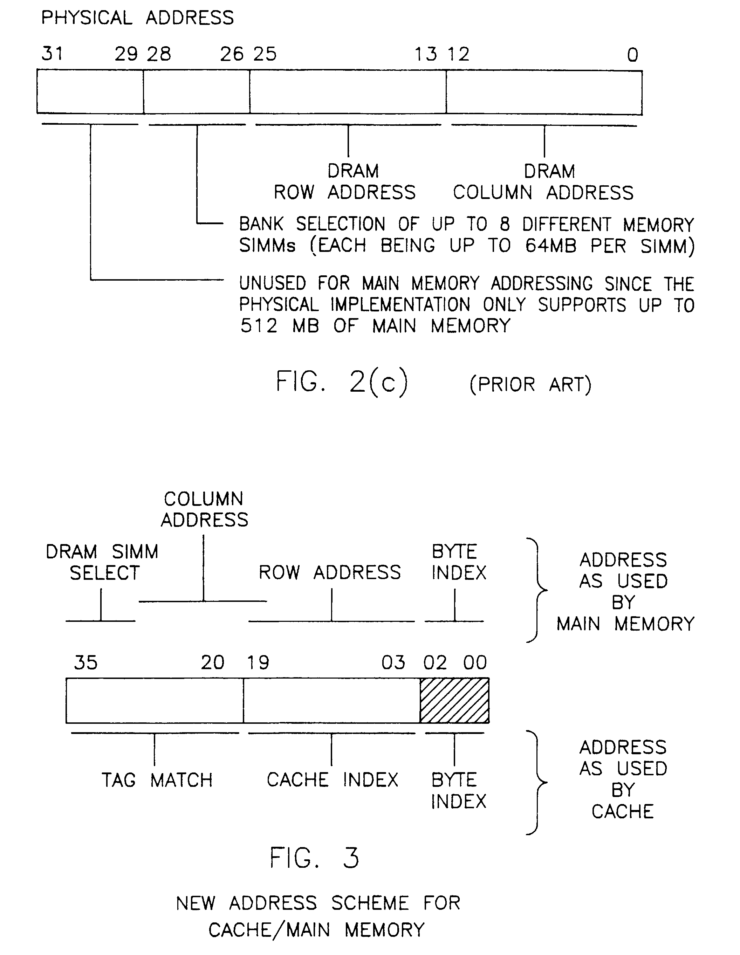

In either the prior art circuit of Figure la or the prior art circuit of Figure 1b, the address provided by CPU 11 to external cache memory 12 or main memory 20 is used as follows. The full address is broken down into different components by the cache memory and main memory controllers. For example, consider the case of a 1 MB external cache controller used in a Sun workstation, SS-10 model 51. The processor module consists of CPU 11, and a cache controller and 1 MB of static RAM serving as cache memory 12, configured much like Figure 1b. CPU 11 generates a 36 bit physical address to cache memory 12 and main memory 20. Typically, the address is broken down into an (word) index value to the cache data/tag RAMs, a byte index (to the cache word), and a tag match value. Figure 2a shows an example of this address breakdown.

When the address is sent out by CPU 11, only the cache index is needed for a cache memory lookup under the most frequent design implementations. This cache index is required to start the time-critical cache memory access. When a cache memory is to be addressed, only the component data/tag RAMs are used. The byte index and tag match components of the full address are not needed until later during the cache memory access for the cache tag comparison, but that occurs later after the tag information has been fetched from the cache memory. In this example, the low order address bits (19→3) form the index to a 128Kx64 bit cache array. Since, in this example, the cache data word is 64 bits or 8 bytes wide, the lower 3 address bits of the CPU address are used to specify a single byte in the 64 bit word defined by the low order address bits. The remaining address bits (35→20) form the tag match value to allow unique identification of the cached memory data. The "tag" is the label that uniquely identifies the data value stored in the cache data RAMs. Since the cache is much smaller than main memory, a label must be associated with each value in the cache data RAMs to uniquely identify which main memory location is actually in the cache.
A typical tag is made up of several different components, such as the address identifier, permission bits, and context/user ID.

The address identifier is usually the "complete" address with the lower cache index bits stripped off for direct mapped caches or additional bits added in for multi-way set associative caches. The permission bits usually explain details about the accesses, i.e. writable location, supervisor only, dirty, etc. The context/user/ID bits keep a distinction between different CPU tasks (running concurrently) using the same memory locations. Prior art references regarding caches and their implementations include "The Cache Memory Book", by Jim Handy, Academic Press 1993, ISBN #0-12-322985-5; and "Computer Architecture - A Quantitative Approach", John Hennessy and David Patterson,
Morgan Kaufman Publishers, 1990, ISBN #1-55860-069-0.

Although there can be one tag per location in the data RAM, usually to save cost a single tag usually represents several locations called a "block" or "line".

Main memory 20 on the other hand uses the address a little differently than does cache memory 12. For example, the address when used by main memory 20 is broken down as shown in Figure 2b, again, referring to the Sun SS-10 workstation example of a 36 bit physical address from CPU 11, and in which the DRAMs of main memory 20 are formed as a plurality of single in-line memory modules (SIMMs). Although it's the same physical address, the bits are used differently.

Main memory in a modern computer system consists of Dynamic Random Access Memory ("DRAM") devices. To save on pins, the chip manufacturers put them in packages that only allow them to use approximately half the address at each control strobe. Hence, a DRAM device requires two separate values (row address and column address) to be strobed sequentially.

Main memory 20 is typically formed of multiple DRAM chips bundled together to form a "bank" of memory of a desired size. Common bank sizes used currently in computers are 4, 16, 32, or 64 MegaBytes (MBs). Multiple banks of memory are usually supported in a computer system. The upper bits of the address are used to select among the different banks. The lower bits are divided into the different halves of the memory address for loading into the DRAM devices. Consider the 32-bit main memory address used in a Sparcstation 10 machine available from Sun Microsystems of Mountain View, California. Figure 2c depicts the 32 bit address into groupings of address bits. In this example, these lower bits are physical address bits 25 through 0. A typical DRAM chip only provides up to 13 address pins (depending on it's physical arrangement, e.g., 1Mx4, 4Mx1, 4Mx4, 2Mx8, etc.) to access data. Such a device would require an address greater than 13 bits to successfully access all the internal bits. Hence, two distinct address strobe sequences are required to load the entire address into the device. These two address strobes are commonly known as the "Row Address Strobe" (RAS) and "Column Address Strobe" (CAS). These address strobes (separate control signals on the DRAM device) cause the row and column addresses (respectively) to be sequentially loaded into the DRAM from common row/column address pins.

In general DRAM devices operate with the row address value first and the column address value second. DRAM devices do not care which order you load the address bits, since DRAMs always define the first address strobe as the row address because it selects among the multitude of rows in the DRAM device memory array. Similarly, the second strobed address is always the column because this set of address bits physically selects a specific column in the DRAM device memory array. The intersection of the selected row and column lines causes a particular location in the DRAM to be accessed.

Externally the user can consistently swap the address (row and column) bits freely and the DRAM will properly access desired data locations. However, there is a compelling reason for not doing this: DRAMs can improve their performance (read/write speed) dramatically if accesses are made sequentially. Computers, especially for caches, frequently access data in main memory in a sequential manner. Hence, swapping the row and column values would destroy the sequentiality of the normal physical address as seen by the DRAM, and thus the DRAMs performance would be severely impacted. This sequential address is frequently referred to as page mode or static column addressing. A DRAM with this feature can sequentially access data by altering only the lower bits of the column value and reduce access times to data in half for a limited range of column values. This speed advantage achieved with sequential accessing of DRAMs is a major reason why the prior art has not looked very deeply into alternative addressing schemes.

This means a designer is faced with a dilemma if it is desired to reduce the number of address signals. This dilemma occurs because main memory 20 prefers upper address bits and since main memory DRAMs require row addresses to be strobed in before column addresses are strobed in. On the other hand, the cache always needs the lower bits of the physical address (starting from 0 up to N, where N is the maximum address bit used to access the cache data RAMs). However, the lower bits of the physical address happen to correspond to the DRAM Column Address value used by main memory 20. As explained in the previous description of DRAM addressing, it is highly preferable to make the lower bits of physical address serve as the column address because of the improved performance from DRAMs when addressing is performed in a sequential manner. Since the DRAM Row Address value consists of upper address bits, these bits were completely different from the cache indexing address value; hence one could not share the two values to address both cache memory 12 and main memory 20. Because of this dilemma, designers implementing high performance computer systems required the full address to provide the low order bits for the cache RAMs and the high order bits for the main memory, so accesses of cache memory 12 and main memory 20 can begin simultaneously. The solution in the prior art has been to simply provide the full address value from CPU 11.

The invention concerns a method for operating a computer system according to the preamble of claim 1 which is characterized by the features of the characterizing part of claim 1, and a computer system according to the preamble of claim 8 which is characterized by the features of the characterizing part of claim 8.

In accordance with the teachings of this invention, a computer system and method are taught utilizing main memory and cache memory addressed in a novel manner to increase speed of operation of the computer system while minimizing the number of address pins required to fully address cache memory and main memory. A CPU address bus is shared between the cache memory and the main memory, having fewer bus leads than is required to fully address the entire content of main memory. When a memory access is desired, a first set of address bits are output by the CPU on the CPU address bus, which are a sufficient number of address bits to access cache memory. These bits also serve as the row bits for main memory, and are stored in a main memory address buffer. In the event of a cache hit, the appropriate data is read from or written to cache memory. Conversely, in the event of a cache miss, the row address bits stored in the main memory address buffer are strobed into main memory, and the CPU outputs the remaining memory bits, which serve as the column address bits required to access the desired memory location within the main memory.
Figure 1a is a block diagram depicting a typical prior art computer system utilizing cache and main memory, with separate main memory address and cache address busses;
Figure 1b is a block diagram of a typical prior art computer system utilizing main memory and cache memory, with a shared memory address bus;
Figure 2a is a cache memory address breakdown typical of prior art;
Figure 2b is a main memory address breakdown typical of the prior art;
Figure 2c is a breakdown of the 32 bit main memory address used in a spark station ten machine;
Figure 3 is a address bit breakdown suitable for use with both cache memory and main memory in accordance with one embodiment of this invention;
Figure 4 is a block diagram depicting a computer system suitable for use in accordance with one embodiment of the present invention;
Figure 5 is a more detailed diagram of a computer system operating in accordance with one embodiment of the present invention;
Figure 6 is a set of timing diagrams associated with the embodiment of Figure 5; and
Figures 7a and 7b are a flow chart depicting the operation of one embodiment of this invention which utilizes a shared address bus 46 for use by both main memory 40 and cache memory 42;
Figure 7c is a timing diagram depicting the timing associated with the embodiment of Figures 7a and 7b;
Figure 8 is a timing diagram depicting the operation of one embodiment of this invention pertaining to multiplexed addressing;
Figure 9 is a block diagram depicting one example of a -structure of this invention suitable for use with page mode DRAM main memory operation;
Figure 10 is a depiction of address bit utilization which, with reference to Table 1, depicts address bit utilization of the prior art and alternative embodiments of the present invention for the exemplary embodiment of Figure 9; and
Figure 11 is a timing diagram depicting one example of cache read miss page mode memory operation in accordance with the teachings of this invention.

In accordance with the teachings of this invention, the way an address is used to index cache memory and address the main memory is changed as compared to the traditional usage of this address in the prior art. In accordance with the teachings of this invention, the lower address bits are still used to index the cache memory. Since the RAM used in cache memory is typically small compared to the main memory structure, the number of address bits required to address cache memory is comparable to the number of row or column address bits required to address main memory. However, in accordance with the teachings of this invention, the DRAM addressing method for the row and column addresses is reversed. By doing this, only half as many address lines (roughly speaking) are required to access main memory as compared with the prior art when using those same address lines to efficiently address cache memory simultaneously.

One embodiment of the novel memory address bit utilization of this invention is depicted in Figure 3, suitable for use with cache memory and main memory in a highly efficient manner. By rearranging the address usage as taught by this invention, the number of address pins required at any one time is reduced to equal that number of address pins required to address the external cache RAMs. In the example shown in Figure 3, the number of address pins is reduced from 33 to 17 for a cache memory of up to 1 MB and a main memory of up to 4 GB.

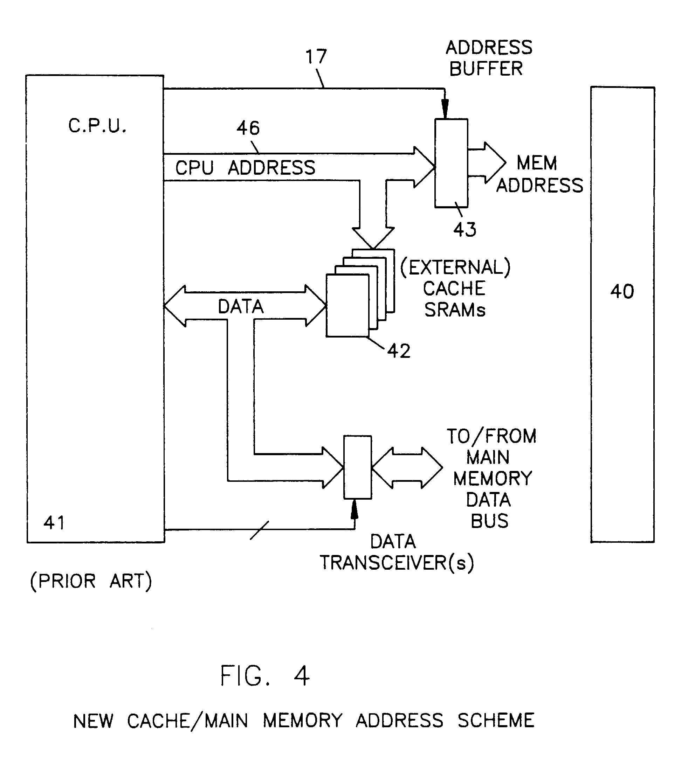

Figure 4 is a diagram depicting one embodiment of a computer system constructed in accordance with the teachings of this invention which advantageously utilizes the novel system addressing taught by the present invention. Externally, this embodiment looks somewhat similar to Figure 1b. However, there are several important differences. A first significant difference between the novel structure of Figure 4 and the prior art structure of Figure 1b is the use of fewer pins from CPU 41, in this exemplary embodiment 17 pins versus 33 address pins in the prior art example of Figure 1b, for identical cache and main memory, respectively, architectures and size. A second significant difference in accordance with this invention is that external address buffer/mux 43 include a registered buffer to hold the "row" and "column" address values which are provided by CPU 41, column address first, and row address second, and which are applied by external address buffer/mux 43 to main memory 40 row address first, column address second. In accordance with one embodiment of this invention the multiplexer function of providing column address first, and row address second, is performed by CPU 41, thereby saving component cost. The memory control logic (formed as part of main memory 40) strobes the appropriate control signals to capture the correct address (row or column at the right time.

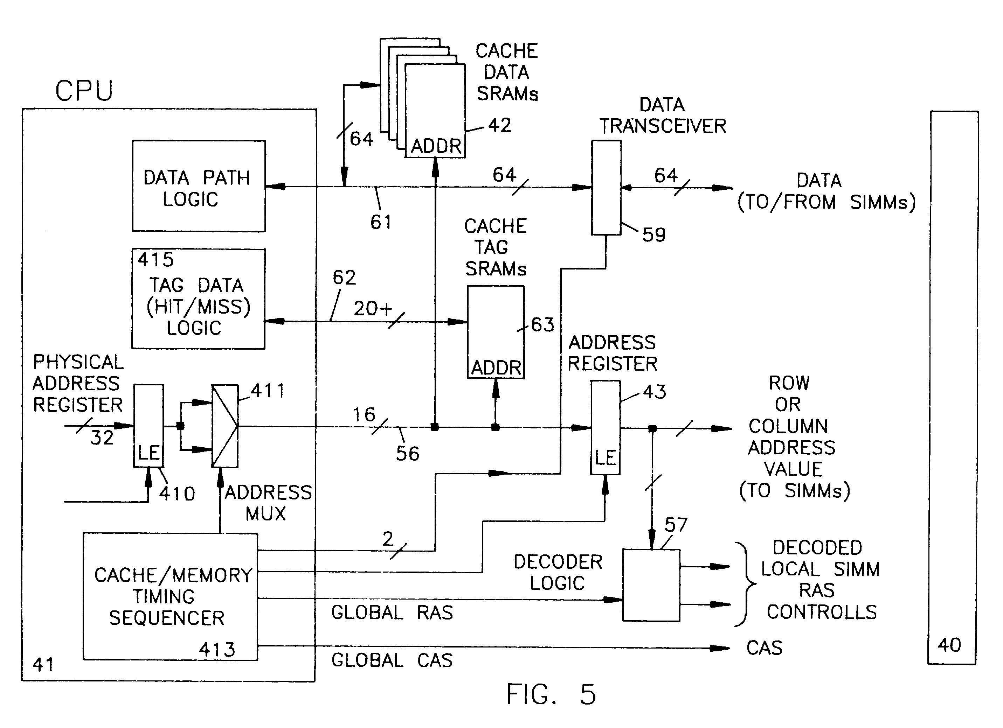

Figure 5 is a diagram of one embodiment of this invention depicting how CPU 41 operates internally on the addresses to provide them to devices external to CPU 41, including main memory 40 and cache memory 42. Of interest, CPU 41 is able to operate on the addresses in much the same way as in the prior art while still obtaining the benefits, including a pin reduction afforded by the different way the address pins are utilized, in accordance with the teachings of this invention.

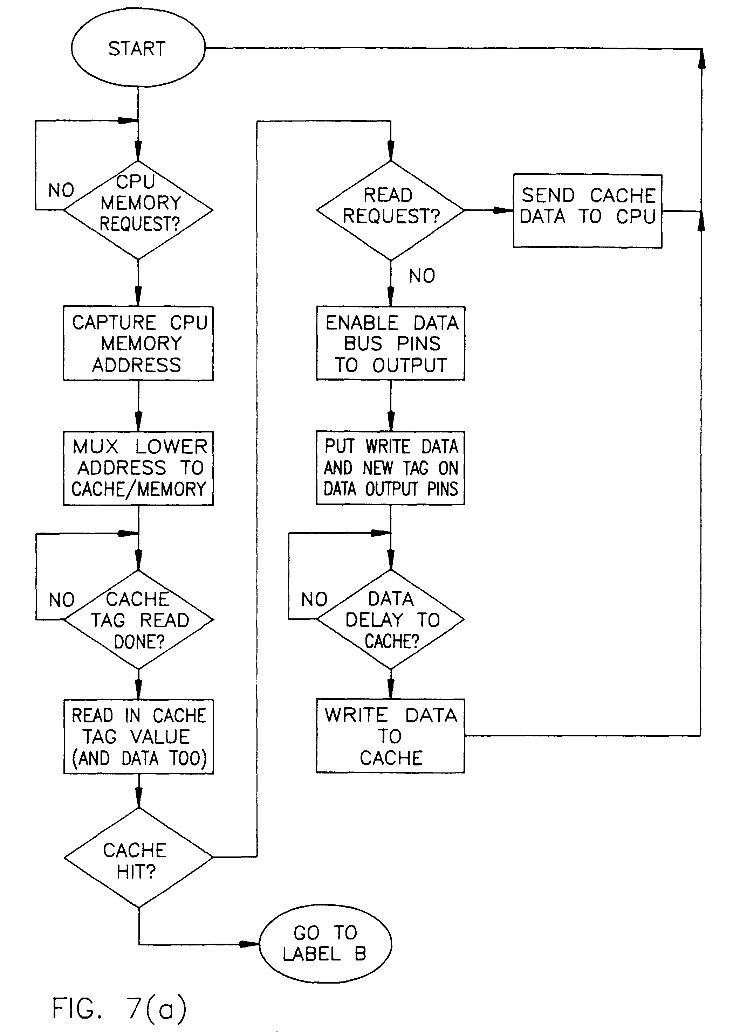

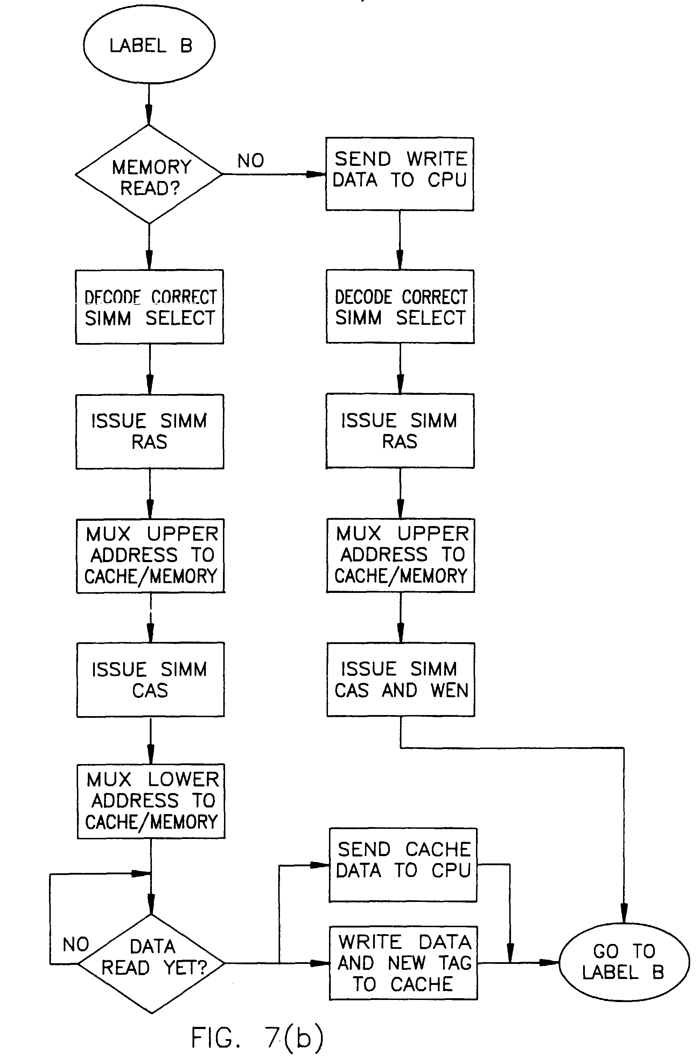

Figures 7a and 7b form a flow chart depicting the operation of a computer system in accordance with the teachings of this invention in accordance with the examples herein described and showing how this invention works in the event a memory access is for the purposes of writing data to memory, rather than reading from memory, and in the alternative scenarios of either a cache hit or a cache miss.

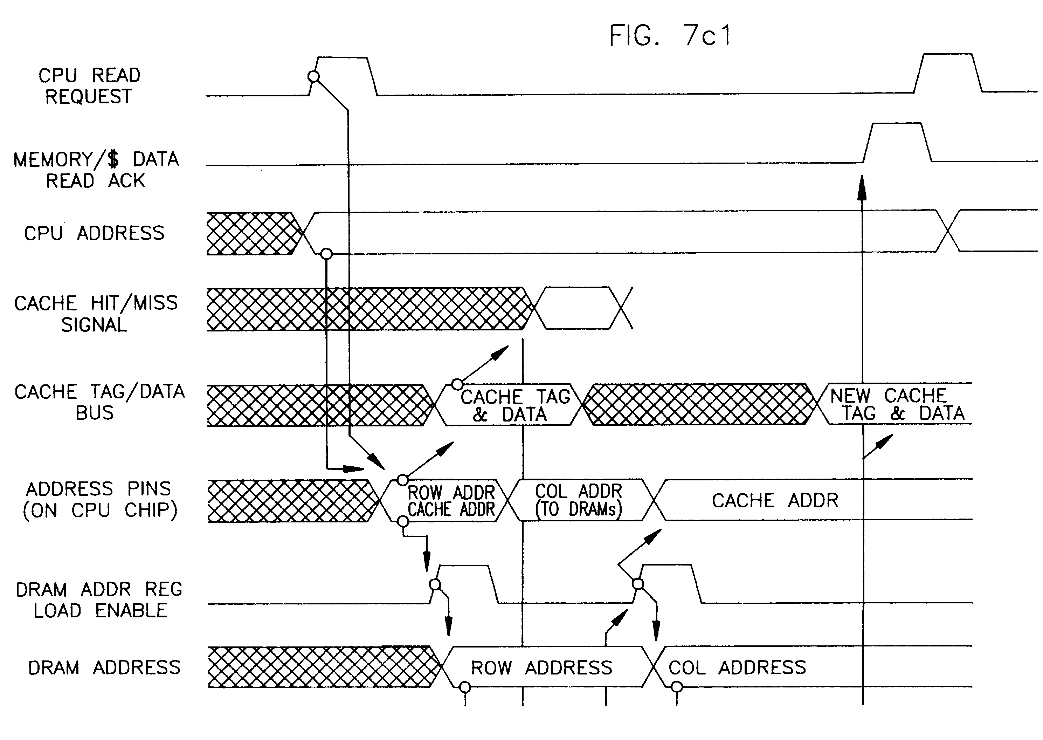

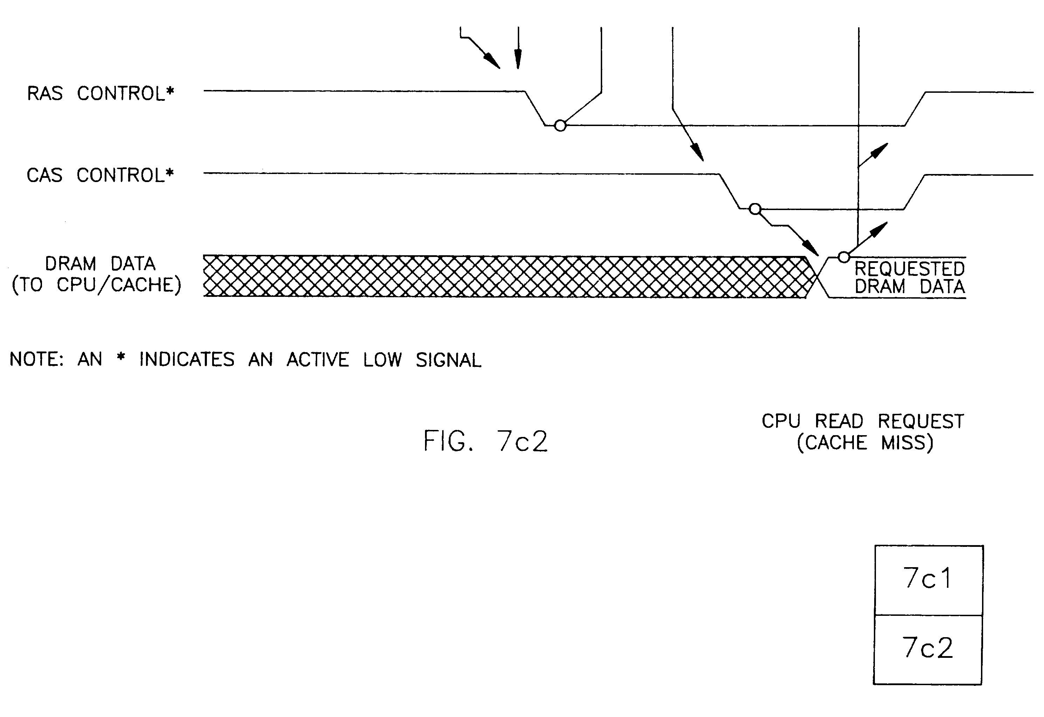

Figure 7c is a timing diagram depicting the operation of this embodiment. In operation, internal to CPU 41, a new memory access request is generated. This causes the address to be captured in physical address register 410. The first (lower) part of the address (the row/cache index value) is selected by address multiplexor 411 and is sent simultaneously via bus 56 to cache memory 42 and to address register/buffer 43. This step initiates the cache memory 42 access while at the same time starting the address setup time to main memory 40. This step also allows the memory (row) address value to be decoded by decoder 57 to select among the different memory devices forming main memory 40. Once the address has been sent to cache memory 42 and main memory 40, CPU 41 waits for the required address and data access propagation periods.

The data from cache memory 42 is loaded into CPU 41, and a cache hit/miss check is performed by tag data hit/miss logic 415 of CPU 41 on tag data accessed from tag memory 63 via bus 62 to determine if the desired data is truly stored in cache memory 42. Should the data reside in cache memory 42 (a cache hit) then no further addresses need be sent to main memory 40. In this event, if the operation is a read, data is sent from cache 42 to CPU 41. On the other hand, if the operation is a write, data is provided by CPU 41 on data bus 61 and written into cache memory 42; and tag data is provided by CPU 41 on tag bus 62 and written to tag memory 63.

Conversely, if the data does not reside in cache memory 42 (a cache miss), cache/memory timing sequencer 413 strobes (via a global RAS signal) the row address stored in address register 43 into the correct memory device of main memory 40 as selected by decoder 57, and sends the column address from address multiplexor 411 to main memory 40. Once the column address has reached main memory 40, the column strobe control (CAS) signal is generated by CPU 41 and used to load this second half of the address into main memory 40. After waiting the access period required by main memory 40, the data is sent to CPU 41 on bus 61 via data transceiver 59. As required, the next column address may have to be sent out by CPU 41 to access the next sequential word(s) in main memory and a new column address strobe asserted.

In the event this last operation was a write in response to a cache miss, data is written to, rather than read from, main memory 40, utilizing a write enable (WEN) signal from CPU 41.

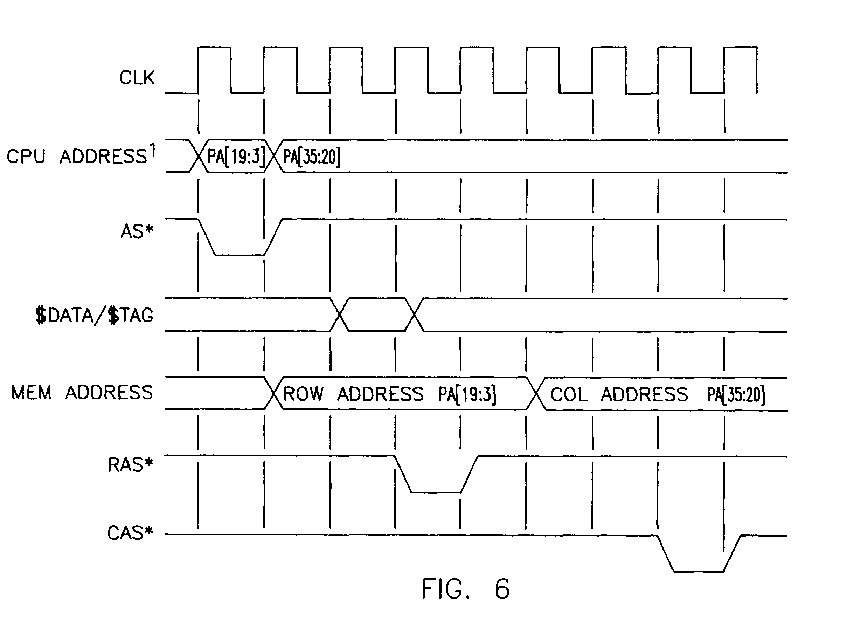

One example of suitable timing for the operation of the novel CPU and memory structure shown in Figures 4 and 5 is depicted in the timing diagram of Figure 6. The beginning of a new address cycle is denoted by the address strobe signal (AS∗). The first address out is the physical CPU address required to index a cache access. This guarantees that normal cache accesses, which are timing critical, are not adversely affected in any way. In the timing example, it is shown as a synchronous system, i.e., a clock provides timing to the system (CPU 41 and cache memory 42). Synchronous operation is not required by the invention, but simply shows a sample implementation approach. Because the first half of the address now represents the "row" address of the DRAMs of main memory 40, i.e., the first part of the address required to initiate a DRAM access, in accordance with this invention, there is no delay to starting a main memory access.

The row address for main memory 40 is loaded into memory address register 43 at the same time the address is applied to cache memory 42. Prior art systems do not attempt main memory DRAM accesses until after the cache memory is determined to not contain the requested information. However, since electrical loading on the DRAM address lines is usually heavy, by providing the address at the same time to the main memory DRAM pins as this address information is applied to cache memory 42, the maximum amount of propagation time is provided to the DRAMs of main memory 40. This saves valuable time off any subsequent memory access.

Once cache memory 42 determines that the required data is not available, a main memory access can begin. Since the row address is already captured in row/column address register 43, CPU 41 now puts out the column address on the reduced number of address pins forming bus 46. Thus, in accordance with the teachings of this invention, main memory 40 receives the entire address information when required to do a main memory access using a reduced number of address pins from CPU 41, and a consequent reduction in the width of address bus 46.

For various cache data sizes and performance criteria, the address may be strobed in slight variations of this to allow for different cache line sizes and/or to initiate DRAM prefetch operations. The way the address is strobed after the initial access depends to a large degree on the width of the memory data bus from the DRAM modules, the line size of the cache, and the size of the CPU data request.

For example, if the cache line size is 32 bytes and the DRAM memory SIMMs provide 256-bits (or 32-bytes) of data per address, then the address sequence is:
Row Address
RAS (Row Address Strobe) Control
Column Address
CAS (Column Address Strobe) Control

Alternately, for the example where the cache line size is 32 bytes and the DRAM memory SIMMs provide 128-bits (or 16 bytes) of data per address, then the address sequence is:
Row Address
RAS (Row Address Strobe) Control
Column Address

CAS (Column Address Strobe) Control
Column Address + 16
CAS (Column Address Strobe Control)

In alternative embodiments, there is provided some form of data multiplexing on the wide data paths to reduce their size to allow them to be loaded into the processor data cache. In the example shown in Figure 5, for example, the cache/CPU data path 61 is shown to be 64 bits wide, so a 2:1 mux (for 128-bit wide memory SIMMs) or a 4:1 mux (for 256-bit wide memory SIMMS) are used in alternative embodiments.

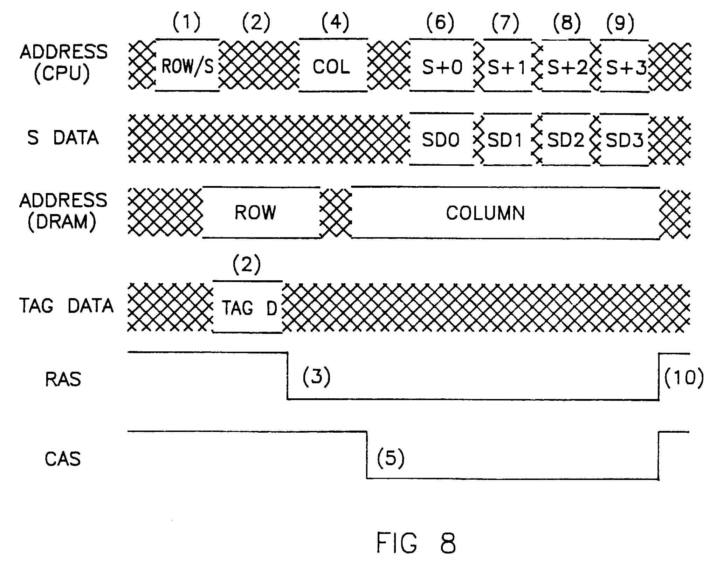

Also, since we are using the same address pins to access cache and main memory, it is provided in certain embodiments that the pin timing is controlled to allow the proper loading of the cache data RAMs as the data flows back from the main memory SIMMs. A simple example of such a timing sequence is depicted in Figure 8. This example is of a 256 bit wide memory bus, multiplexed down to 64 bit quantities.

In other alternative embodiments row addresses and column addresses may be combined in a single one of these multiplexed bit quantities, and appropriately stored and used as required by the cache memory controller or main memory controller.

The following exemplary embodiment, referenced to Figure 8, avoids having to strobe the column address value for the sequential DRAM addressing. The cache line size in this example is 32 bytes. In the timing sequence shown in Figure 8, the CPU makes a request to the cache controller unit. At step 1, the cache logic swaps the address and sends out the combined cache index address and memory ROW address. When the data comes back from the tag RAMs at step 2 it is checked to see if it is a cache miss. If a cache miss occurs (as in this timing example), the row control strobe to the memory logic is asserted in step 3. A new address (the column address value) is placed on the address pins in step 4. After a sufficient time interval (step 5), the column control strobe is asserted to the memories. After waiting the access delay to the memory devices (step 6) the first data is read back to the CPU and the data cache RAMs. Since in this example the address pins provide bits which serve as cache memory index as well as main memory address values, then we must switch them back to the cache index value for the desired address prior to storing the data into the cache memory. After writing the first data word in the cache (and returning the data to the CPU), the second data word and address arrive in step 7 -- in this case the address comes from the CPU with appropriate increment and the data from the memory multiplexer circuit. Steps 8 and 9 simply show the remaining words being multiplexed down to the 64-bit data bus in sequence to complete the cache line fill.

A simple alternative to repeatedly incrementing the index cache address on the CPU pins is an embodiment in which a burst cache RAM is used that only requires the first address and then under proper strobe control automatically increments the address (up to the cache line size) internally in the cache memory.

For systems that also utilize static column or page mode accesses to DRAM devices of main memory 40, the invention allows sufficient flexibility to support most of these features as well. The way page mode is supported in accordance with this invention depends on the reasons page mode is desired, and the amount of page mode main memory.

To support page mode DRAM main memory operation, in an alternative embodiment of this invention a few of the address bits are reassigned to allow the DRAMs to perform a limited page mode type of operation. Depending on the address range of the main memory and the cache memory, as well as the data width, this embodiment may involve no more than a few address bit swaps, or merely require the addition of a few additional address pins. These additional pins, if required, form redundant address values that allow a small portion of the "new column" address value to be incremented in order to function properly with the normal page mode operation of DRAMs.

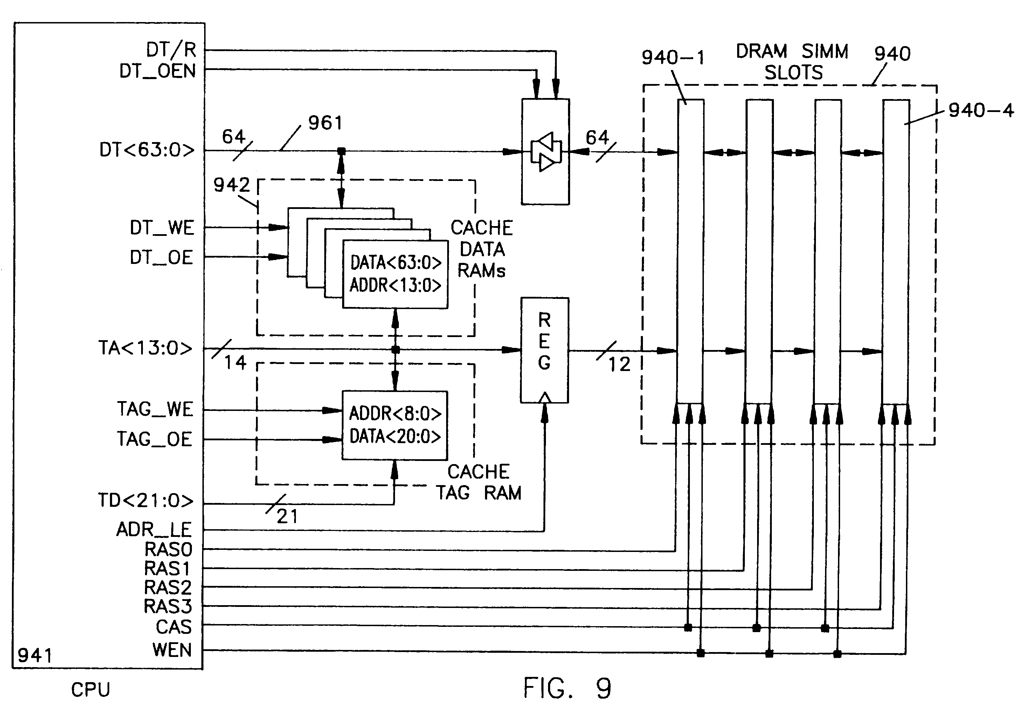

In the example of Figure 9, a system is designed around an external (to CPU 941) cache memory 942 of 128 kilobytes. Main memory 940 consists of four memory SIMM slots 940-1 through 940-4, each designed to support up to 16 MB per SIMM for a total main memory of 64 MB.

Cache memory 942 is a direct mapped cache memory and uses a 32 byte line size. Data path 961 to and from main memory 940 and cache memory 942 is 64 bits (8 bytes) wide.

This embodiment uses the novel addressing technique of this invention to minimize address pins. However, because the line size in cache memory 942 is 32 bytes and the data path to main memory 940 only allows each DRAM memory access to retrieve 8 bytes at a time, some form of page mode addressing/accessing is used.

To implement this embodiment, one has to analyze the addresses required of four different features of the problem: external cache memory 942 requirements; total physical memory range; main memory 940 (for non paged) with the novel addressing scheme of this invention; and page mode requirements.

In this example, external cache memory 942 is a 128KB cache arranged as 16K X 64 bit memory (for example, using four 16K x 16 SRAM chips). This means the address requirements of a 16K entry RAM device is 14 bits (2¹⁴ = 16,384 possible address locations). Thus a minimum of 14 address lines from CPU 940 are required to address external cache memory 942.

The total memory space is 4 GB in this example, assuming a 32 bit address range. However, in this example only 64 MB of the address space is physically implemented. This means CPU 940 would, using prior art techniques rather than the novel address technique of this invention, provide 26 bits of address information.

The DRAMs of main memory 940 in this example are arranged as four distinct banks 940-1 through 940-4 of 2M x 64 (16 MB total). A 2M x 8 DRAM (eight per SIMM) is actually a 16 MB device arranged as 2M x 8. A normal 16 MB x 1 DRAM would require 12 row address values and 12 column address values. However, since it is implemented in an x8 configuration, the DRAM requires 12 row and 9 column addresses. Note: 12 + 9 = 21 bits, and 2²¹ yields 2M entries which is exactly what we require to address a 2M x 8 device.

**TABLE 1**

| PRIOR ART DRAM ADDRESSING | |
|---|---|
| 00 = SIMM0 | |
| 00 = SIMM1 | ROW ADDRESS = BITS <23:12> |
| 10 = SIMM2 | COLUMN ADDRESS = BITS <11:03> |
| 11 = SIMM3 | |
| | |

| EXEMPLARY EMBODIMENT OF NON-PAGE MODE DRAM ADDRESSING | |
|---|---|
| 00 = SIMM0 | |
| 01 = SIMM1 | ROW ADDRESS = BITS <14:03> |
| 10 = SIMM2 | COLUMN ADDRESS = BITS <23:15> |
| 11 = SIMM3 | |
| | |

| EXEMPLARY EMBODIMENT OF PAGE MODE DRAM ADDRESSING | |
|---|---|
| 00 = SIMM0 | |
| 01 = SIMM1 | ROW ADDRESS = BITS <16:05> |
| 10 = SIMM2 | COLUMN ADDRESS = BITS <23:17>, <4:3> |
| 11 = SIMM3 | |

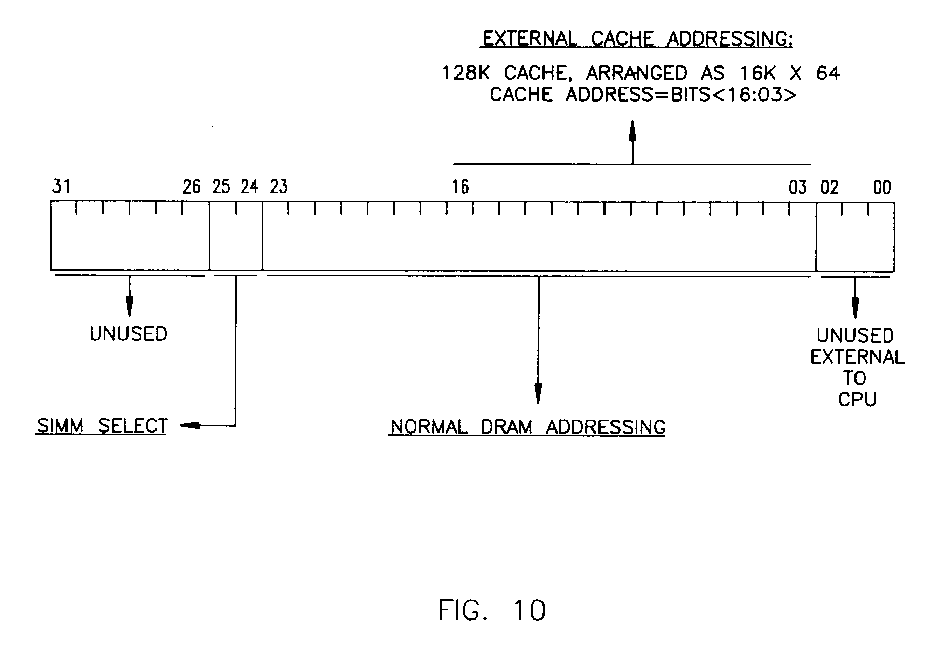

Using the novel addressing technique of this invention, but not using page mode addressing requires, as shown in Table 1 and with reference to Figure 10, the 21 address bits (CPU Address [23:0] of which [2:0] are not used due to the 64 bit/8 byte wide data path) to address the 2M entries on the DRAMs of main memory 940. These 21 address bits would, in the prior art and as shown in Table 1, be broken down as 12 row and 9 column address values, i.e., Row Address = CPU Address [23:12], Column Address = CPU Address [11:03]. In accordance with this invention this is reversed so that the new Row Address is [14:03] and the Column Address is [23:15].

This arrangement of address bits from CPU 940, referred to as TA<[13:0] in Figure 9 provides the index value for cache memory 942 (14 bits) and provides the row/column address values to main memory 940. The address bit mapping of this example is shown in Figure 10.

The upper two column address bits are not used by main memory 940, but appear as redundant signals to meet the minimum cache index address requirement. The Row Address + Column Address bits, when combined inside main memory 940, form the complete set of CPU Address [23:03]. Also, since the Column address is only 9 bits long and the address register/signals to main memory 940 is 12 bits wide, dummy values are placed in those three unused address bit positions.

To handle the page mode requirements consider the type of sequential accesses performed by the system. In this example a 32-byte sequential access is performed whenever a new line is loaded from main memory 940 into cache memory 942 or a line is written out to cache memory 942 (assuming a write back cache protocol). Since a data access to memory only yields 8 bytes per access, three additional accesses are required in page mode to read the remaining 24 bytes data from a line fill (or store) operation. To accommodate this requirement of four sequential accesses requires the two least significant address bits in the column component of the address to increment by one with each access.

Since cache line fill operations are sequential and wrap modulo the line size, only the lower two bits are incremented in the column address. Hence, slightly different row/column address breakdowns are used, as compared to the non-paged embodiment of this invention, as described above. The incrementing values of the internal CPU address are, in this example, address bits [4:3]. In one embodiment, the row/column address bits are shifted slightly so the address as seen by main memory 940 (when reassembled) is as depicted in Table 1.

To maintain the consistency of the cache index address, the upper two bits of the pin address to cache memory 942 are adjusted to provide all 14 bits as required.

In this example, a sequential burst read or write for the cache would look like:
Row Address (CPU Address [16:05])
(1) Col Address (CPU Address [23:17], [04:03] )
(2) Col Address (CPU Address [23:17], ([04:03]+1) )
(3) Col Address (CPU Address [23:17], ([04:03]+2) )
(4) Col Address (CPU Address [23:17], ([04:03]+3) )

To address four distinct banks of DRAMs, two more address bits are required and decoded out to produce four bank select controls (DRAM Row Address Strobe or RAS signals). In the example of Figure 9, these four bank select control bits are decoded by CPU 941 and sent out as four separate pins, labelled RAS0, RAS1, RAS2, and RAS3, respectively.

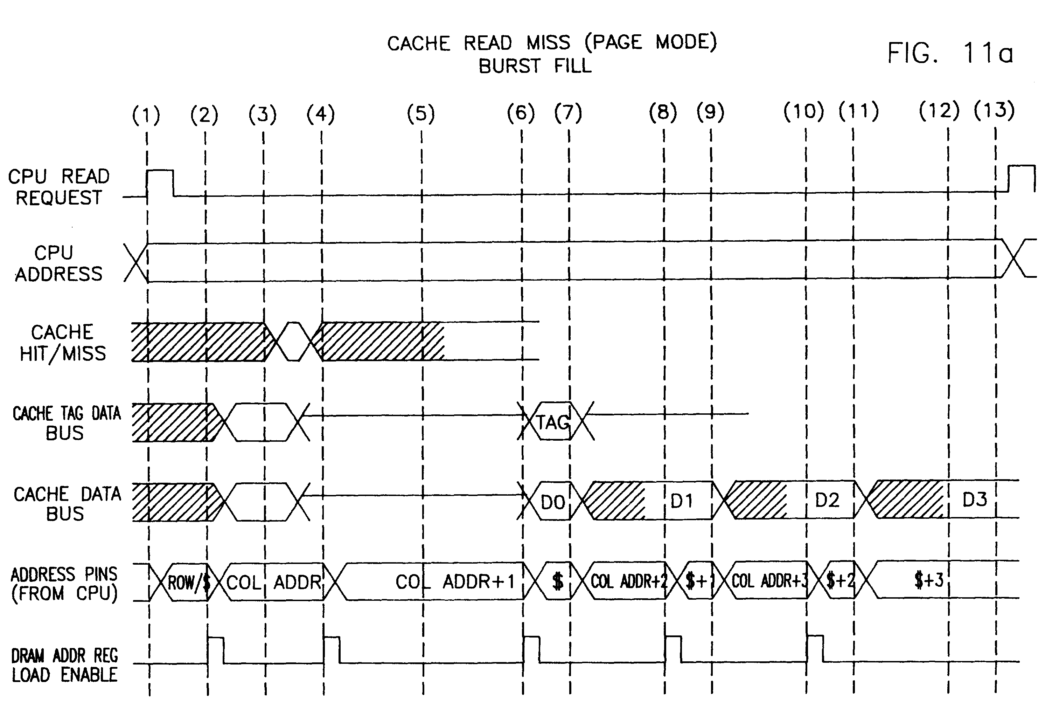

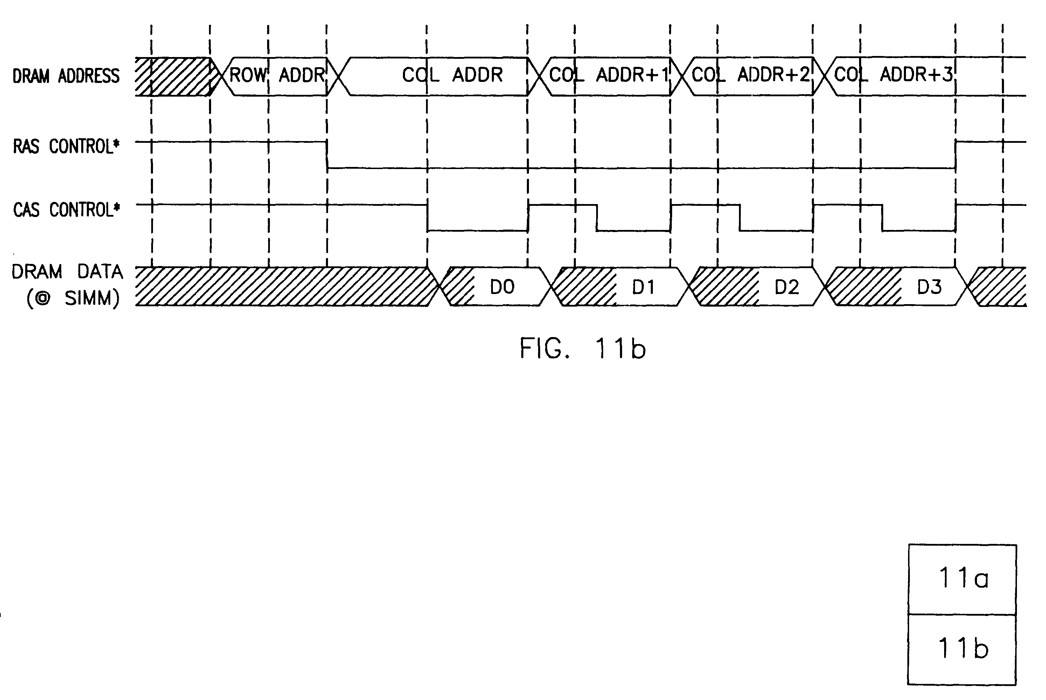

The example shown in Figure 11 is a cache read miss (32 byte line fill) on a "clean" cache line, which starts at Step 1 with a CPU read request and read address. The cache controller/memory interface unit sends out the combined cache index and row address on the address pins of the CPU. After the address reaches the external cache SRAMs and DRAM address latch at Step 2, the row value is captured in the DRAM address latch and starts the address setup time interval to the DRAM SIMMs. The data from the cache SRAMs is also available now and is brought into the cache control hit/miss logic. Because the row address to the DRAMs is now latched and the cache data/tag information has been retrieved, the address pins are switched to the column address value. At Step 3 the internal cache logic has determined whether the data is a cache hit. In this example, it is not a valid location (i.e. a cache miss) so at Step 4 the desired main memory SIMM is accessed via a row address strobe (RAS). Because the DRAMs specify zero ns hold time on the address relative to the RAS control, at approximately the same time the DRAM address latch is strobed to capture the column address value. The next (incremented) column address value is setup on the CPU address pins to get ready for the first page mode cycle.

After the DRAM RAS to CAS minimum interval, the column address strobe (CAS) is asserted at Step 5 to latch the column address into the DRAM devices of the selected memory SIMM. After the proper access time has been allowed to get the data out of the DRAM, the column address is given a new value at Step 6 by loading the next column address value into the DRAM address latch. Because data is also coming back to the cache at this time, the proper SRAM address is placed back on the cache pins for the duration of the write operation. However, in one embodiment, specialized burst mode SRAMs are used and thus eliminate this requirement because they keep an internal copy of the address and perform the incrementing function internally, relieving the cache controller of this task.

In this embodiment, note that the cache tag values are updated (usually on the first write of the line) once, not every cache data RAM write during the burst line fill operation.

The CAS control is de-asserted to start the CAS precharge time of the DRAM. The DRAM data is sent back to the CPU/cache core for loading into the cache SRAMs at Step 7 and given to the CPU as requested. The CAS control is reasserted after the minimum precharge interval to start the first page mode access. Once the minimal data access time has occurred, the data is sent back to the cache/CPU (for the second time) and the CAS is de-asserted again, at Step 8. This sequence is repeated two more times (at Steps 9, 10, 11, and 12) to complete the four sequential page mode accesses required to read in the 32-bytes required to fill the new cache line.

## Claims

1. A method for operating a computer system including a processor (41), a main memory (40), a cache memory (42), and an address bus (46) coupling said processor (41) to said main memory (40) and said cache memory (42), comprising the steps of:
causing said processor (41) to provide a first plurality of address bits, lower address bits, to said address bus (46) less than all address bits necessitated for accessing said main memory (40);
causing said cache memory (42) to perform a cache memory access based upon said first plurality of address bits;
causing said main memory (40) to use said first plurality of address bits to set up a main memory access operation;
causing said processor (41) to provide a second plurality of address bits, higher address bits, on said address bus (46); and
causing said main memory (40) to use said second plurality of address bits to complete said main memory access operation;
**characterized** in that
said second plurality of address bits is provided to said main memory (40) after determining a cache miss resulting from said cache memory access, said pluralities of address bits being transmitted via said address bus (46) provided with a number of pins less than the total number of address bits required for a full main memory access.

2. The method of claim 1, characterized in that at least some of said first plurality of address bits serve as a row address to said main memory (40) and at least some of said second plurality of address bits serve as a column address to said main memory (40).

3. The method of claim 1 or 2, characterized in that said cache memory access and said initiation of said main memory access is performed simultaneously.

4. The method of anyone of the claims 1 to 3, characterized in that at least some of said first plurality of address bits are decoded to provide a decoded row address strobe signal to select an appropriate one of a plurality of memory banks (940-1 to 940-4) of the main memory (940).

5. The method of anyone of the claims 1 to 4, characterized in that, if said cache memory access results in a cache hit, no further address bits are provided by said processor (40) related to the desired memory access.

6. The method of anyone of the claims 1 to 5, characterized in that said step of providing a second plurality of address bits comprises the step of providing a plurality of sets of address bits in sequence.

7. The method of anyone of the claims 1 to 6, characterized in that said main memory (40) is accessed as a page mode memory.

8. A computer system comprising a processor (41), a main memory (40), a cache memory (42), and an address bus (46) coupling said processor (41) to said main memory (40) and said cache memory (42), and further
first program control elements for causing said processor (41) to provide a first plurality of address bits, lower address bits, less than all address bits necessitated for accessing the main memory (40), to said address bus (46),
a cache memory controller for causing said cache memory (42) to perform a cache memory access based upon said first plurality of address bits,
a main memory controller for causing said main memory (40) to use said first plurality of address bits to set up an access operation to said main memory 840),
first control elements for causing said processor (41) to provide a second plurality of address bits, higher address bits on said addres bus (46),
second control elements for causing said main memory (40) to use said second plurality of address bits to complete said access operation to said main memory (40),
characterized by
second program control elements for receiving information from said cache memory (42) in response to said cache memory access and for determining if said cache memory access results in a cache miss and, if so for activating said first control elements to provide said second plurality of of address bits on said address bus (46) provided with a number of pins less than the total number of address bits required for a full main memory access.

9. The system of claim 8, characterized in that said main memory (40) is appropriate to use at least some of said first plurality of address bits as a row address and at least some of said second plurality of address bits as a column address.

10. The system of claim 8 or 9, characterized in that said processor (41) is appropriate to cause said cache memory access and said initiation of said main memory access to be performed simultaneously.

11. The system of anyone of the claims 8 to 10, characterized in that said main memory (940) comprises a plurality of memory banks (940-1 to 940-4) and a memory bank decoder for decoding at least some of said first plurality of address bits to provide a decoded row address strobe signal to select an appropriate one of said memory banks (940-1 to 940-4).

12. The system of anyone of the claims 8 to 11, characterized in that said second programm elements are appropriate to cause no further memory access address bits to be provided by said processor (41) when said cache memory access results in a cache hit.

13. The system of anyone of the claims 8 to 12, characterized in that said second programm elements include third control elements for providing a plurality of sets of address bits in sequence.

14. The system of anyone of the claims 8 to 12, characterized in that said second programm elements include fourth control elements for causing said main memory (940) to be accessed as a page mode memory.

## Patentansprüche

1. Verfahren zum Betreiben eines Computersystems, das einen Prozessor (41), einen Hauptspeicher (40), einen Cache-Speicher (42) und einen den Prozessor (41) an den Hauptspeicher (40) und den Cache-Speicher (42) koppelnden Adreßbus enthält, umfassend die Schritte,
den Prozessor (41) zu veranlassen, eine erste Vielzahl von Adreßbits, niedrigerer Adreßbits, an den Adreßbus (46) zu liefern, die kleiner ist als alle Adreßbits, die zum Zugreifen auf den Hauptspeicher (40) benötigt werden;
den Cache-Speicher (42) dazu zu veranlassen, einen Cache-Speicherzugriff basierend auf der ersten Vielzahl von Adreßbits durchzuführen;
den Hauptspeicher (40) dazu zu veranlassen, die erste Vielzahl von Adreßbits dazu zu verwenden, einen Hauptspeicherzugriffbetrieb aufzubauen;
den Prozessor (41) zu veranlassen, eine zweite Vielzahl von Adreßbits, höherer Adreßbits, an den Adreßbus (46) zu liefern; und
den Hauptspeicher (40) zu veranlassen, die zweite Vielzahl von Adreßbits dazu zu verwenden, den Hauptspeicherzugriffbetrieb zu vervollständigen;
**dadurch gekennzeichnet**, daß
die zweite Vielzahl von Adreßbits an den Hauptspeicher (40) nach Bestimmen einer aus dem Cache-Speicherzugriff resultierenden Fehlspeicherung geliefert wird, wobei die Vielzahlen von Adreßbits über den Adreßbus (46) übertragen werden, der mit einer Anzahl von Pins versehen ist, die kleiner ist als die Gesamtzahl von Adreßbits, die für einen vollen Hauptspeicherzugriff erforderlich sind.

2. Verfahren nach Anspruch 1, dadurch gekennzeichnet, daß zumindest einige der ersten Vielzahl von Adreßbits als Zeilenadressen für den Hauptspeicher (40) und zumindest einige der zweiten Vielzahl von Adreßbits als Spaltenadressen für den Hauptspeicher (40) dienen.

3. Verfahren nach Anspruch 1 oder 2, dadurch gekennzeichnet, daß der Cache-Speicherzugriff und das Auslösen des Hauptspeicherzugriffs gleichzeitig durchgeführt werden.

4. Verfahren nach einem der Ansprüche 1 bis 3, dadurch gekennzeichnet, daß mindestens einige der ersten Vielzahl von Adreßbits decodiert werden, um ein decodiertes Zeilenadressen-Strobe-Signal zu liefern, um eine geeignete einer Vielzahl von Speicherbanken (940-1 bis 940-4) des Hauptspeichers (940) auszuwählen.

5. Verfahren nach einem der Ansprüche 1 bis 4, dadurch gekennzeichnet, daß, wenn der Cache-Speicherzugriff in einen Cache-Treffer resultiert, keine weiteren Adreßbits durch den Prozessor (40) bezogen auf den gewünschten Speicherzugriff geliefert werden.

6. Verfahren nach einem der Ansprüche 1 bis 5, dadurch gekennzeichnet, daß der Schritt des Lieferns einer zweiten Vielzahl von Adreßbits den Schritt des Lieferns einer Vielzahl von Gruppen von Adreßbits in Folge umfaßt.

7. Verfahren nach einem der Ansprüche 1 bis 6, dadurch gekennzeichnet, daß auf den Hauptspeicher (40) als ein Seitenmodusspeicher zugegriffen wird.

8. Computersystem, umfassend einen Prozessor (41), einen Hauptspeicher (40), einen Cache-Speicher (42) und einen den Prozessor (41) an den Hauptspeicher (40) und den Cache-Speicher (42) koppelnden Adreßbus (46), und ferner
erste Programmsteuerelemente, um den Prozessor (41) zu veranlassen, eine erste Vielzahl von Adreßbits, niedrigerer Adreßbits, die kleiner als sämtliche Adreßbits ist, die zum Zugreifen auf den Hauptspeicher (40) erforderlich sind, an den Adreßbus (46) zu liefern,
einen Cache-Speichercontroller, um den Cache-Speicher (42) dazu zu veranlassen, einen Cache-Speicherzugriff basierend auf der ersten Vielzahl von Adreßbits durchzuführen,
einen Hauptspeichercontroller, um den Hauptspeicher (40) zu veranlassen, die erste Vielzahl von Adreßbits zu verwenden, um einen Zugriffbetrieb auf den Hauptspeicher (840) aufzubauen,
erste Steuerelemente, um den Prozessor (41) zu veranlassen, eine zweite Vielzahl von Adreßbits, höherer Adreßbits, an den Adreßbus (46) zu liefern,
zweite Steuerelemente, um den Hauptspeicher (40) zu veranlassen, die zweite Vielzahl von Adreßbits zu verwenden, um den Zugriffbetrieb auf den Hauptspeicher (40) zu vervollständigen,
gekennzeichnet durch
zweite Programmsteuerelemente zum Empfangen von Information von dem Cache-Speicher (42) in Antwort auf den Cache-Speicherzugriff und zum Bestimmen, ob der Cache-Speicherzugriff in einer Fehlspeicherung resultiert und, falls dies der Fall ist, zum Aktivieren der ersten Steuerelemente, die zweite Vielzahl von Adreßbits an den Adreßbus (46) zu liefern, der mit einer Anzahl von Pins versehen ist, die kleiner als die Gesamtzahl von Adreßbits ist, die für einen vollen Hauptspeicherzugriff erforderlich ist.

9. System nach Anspruch 8, dadurch gekennzeichnet, daß der Hauptspeicher (40) dazu geeignet ist, mindestens einige der ersten Vielzahl von Adreßbits als Zeilenadressen und mindestens einige der zweiten Vielzahl von Adreßbits als Spaltenadressen zu verwenden.

10. System nach Anspruch 8 oder 9, dadurch gekennzeichnet, daß der Prozessor (41) dazu geeignet ist zu veranlassen, daß der Cache-Speicherzugriff und das Auslösen des Hauptspeicherzugriffs gleichzeitig durchgeführt werden.

11. System nach einem der Ansprüche 8 bis 10, dadurch gekennzeichnet, daß der Hauptspeicher (940) eine Vielzahl von Speicherbänken (940-1 bis 940-4) und einen Speicherbankdecoder zum Decodieren mindestens einiger der ersten Vielzahl von Adreßbits, und ein decodiertes Zeilenadreß-Strobe-Signal zum Auswählen einer geeigneten der Speicherbänke (940-1 bis 940-4) umfaßt.

12. System nach einem der Ansprüche 8 bis 11, dadurch gekennzeichnet, daß die zweiten Programmelemente dazu geeignet sind zu veranlassen, daß keine weiteren Speicherzugriffadreßbits durch den Prozessor (41) geliefert werden, wenn der Cache-Speicherzugriff in einem Cache-Treffer resultiert.

13. System nach einem der Ansprüche 8 bis 12, dadurch gekennzeichnet, daß die zweiten Programmelemente dritte Steuerelemente zum Liefern einer Vielzahl von Gruppen von Adreßbits in Folge enthalten.

14. System nach einem der Ansprüche 8 bis 12, dadurch gekennzeichnet, daß die zweiten Programmelemente vierte Steuerelemente zum Veranlassen, daß auf den Hauptspeicher (940) als Seitenmodusspeicher zugegriffen wird, enthalten.

## Revendications

1. Procédé de commande d'un système informatique comprenant une unité de traitement (41), une mémoire principale (40), une antémémoire (42) et un bus d'adresses (46) assurant le couplage de ladite unité de traitement (41) à ladite mémoire principale (40) et à ladite antémémoire (42), comprenant les étapes consistant à:
faire en sorte que ladite unité de traitement (41) délivre une première pluralité de bits d'adresse, des bits d'adresse basse, sur ledit bus d'adresses (46) en nombre inférieur à l'ensemble des bits d'adresse nécessaires pour obtenir l'accès à ladite mémoire principale (40);
faire en sorte que ladite antémémoire (42) réalise un accès à l'antémémoire à partir de ladite première pluralité de bits d'adresse,
faire en sorte que ladite mémoire (40) utilise ladite première pluralité de bits d'adresse pour initialiser une opération d'accès à la mémoire principale;
faire en sorte que ladite unité de traitement (41) délivre une seconde pluralité de bits d'adresse, des bits d'adresse haute, sur ledit bus d'adresses (46); et
faire en sorte que ladite mémoire principale (40) utilise ladite seconde pluralité de bits d'adresse pour terminer ladite opération d'accès à la mémoire principale;
caractérisé en ce que
ladite seconde pluralité de bits d'adresse est délivrée à ladite mémoire principale (40) après détermination d'une insuffisance d'antémémoire résultant dudit accès à l'antémémoire, lesdites pluralités de bits d'adresse étant transmises par l'intermédiaire dudit bus d'adresses (46) comportant un nombre de broches inférieur au nombre total de bits d'adresse requis pour un réaliser un accès total à la mémoire principale.

2. Procédé selon la revendication 1, caractérisé en ce qu'au moins certains bits de ladite première pluralité de bits d'adresse servent d'adresse de rangée à ladite mémoire principale (40) et qu'au moins certains bits de ladite seconde pluralité de bits d'adresse servent d'adresse de colonne à ladite mémoire principale (40).

3. Procédé selon la revendication 1 ou 2, caractérisé en ce que ledit accès à l'antémémoire et ladite initialisation dudit accès à la mémoire principale sont réalisés de manière simultanée.

4. Procédé selon l'une quelconque des revendications 1 à 3, caractérisé en ce qu'au moins certains bits de ladite première pluralité de bits d'adresse sont décodés de manière à délivrer un signal impulsionnel d'adresse de rangée décodée afin de sélectionner le bloc approprié d'une pluralité de blocs de mémoire (940-1 à 940-4) de ladite mémoire principale (940).

5. Procédé selon l'une quelconque des revendications 1 à 4, caractérisé en ce que, si ledit accès à l'antémémoire conduit à une disponibilité d'antémémoire, aucun autre bit d'adresse se rapportant audit accès de mémoire désiré n'est délivré par ladite unité de traitement (40).

6. Procédé selon l'une quelconque des revendications 1 à 5, caractérisé en ce que ladite étape consistant à délivrer une seconde pluralité de bits d'adresse comprend l'étape consistant à délivrer une pluralité de jeux de bits d'adresse de manière successive.

7. Procédé selon l'une quelconque des revendications 1 à 6, caractérisé en ce que l'accès à ladite mémoire principale (40) est réalisé comme pour une mémoire en mode page.

8. Système informatique comprenant une unité de traitement (41), une mémoire principale (40), une antémémoire (42) et un bus d'adresses (46) assurant le couplage de ladite unité de traitement (41) à ladite mémoire principale (40) et à ladite antémémoire (42), et, en outre:
des premiers éléments de commande par programme destinés à faire en sorte que ladite unité de traitement (41) délivre une première pluralité de bits d'adresse, des bits d'adresse basse, en nombre inférieur à l'ensemble des bits d'adresse nécessaires pour obtenir l'accès à ladite mémoire principale (40) sur ledit bus d'adresses (46),
un régisseur d'antémémoire destiné à faire en sorte que ladite antémémoire (42) réalise un accès à l'antémémoire à partir de ladite première pluralité de bits d'adresse,
un régisseur de mémoire principale destiné à faire en sorte que ladite mémoire (40) utilise ladite première pluralité de bits d'adresse pour initialiser une opération d'accès à ladite mémoire principale (840),
des premiers éléments de commande destinés à faire en sorte que ladite unité de traitement (41) délivre une seconde pluralité de bits d'adresse, des bits d'adresse haute, sur ledit bus d'adresses (46);
des seconds éléments de commande destinés à faire en sorte que ladite mémoire principale (40) utilise ladite seconde pluralité de bits d'adresse pour terminer ladite opération d'accès à la mémoire principale (40);
caractérisé en ce qu'il comprend
des seconds éléments de commande par programme destinés à recevoir des informations de ladite antémémoire (42) en réponse audit accès à l'antémémoire et à déterminer si ledit accès à l'antémémoire conduit à une insuffisance d'antémémoire et, si c'est le cas, à activer lesdits premiers éléments de commande de manière à délivrer ladite seconde pluralité de bits d'adresse sur ledit bus d'adresses (46) comportant un nombre de broches inférieur au nombre total de bits d'adresse requis pour réaliser un accès complet à la mémoire principale.

9. Système selon la revendication 8, caractérisé en ce que ladite mémoire principale (40) est appropriée pour utiliser au moins certains bits de ladite première pluralité de bits d'adresse comme une adresse de rangée et au moins certains bits de ladite seconde pluralité de bits d'adresse comme une adresse de colonne.

10. Système selon la revendication 8 ou 9, caractérisé en ce que ladite unité de traitement (41) est appropriée pour faire en sorte que ledit accès à l'antémémoire et ladite initialisation d'accès à la mémoire principale se réalisent de manière simultanée.

11. Système selon l'une quelconque des revendications 8 à 10, caractérisé en ce que ladite mémoire principale (940) comprend une pluralité de blocs de mémoire (940-1 à 940-4) et un décodeur de bloc de mémoire destiné à décoder au moins certains bits de ladite pluralité de bits d'adresse de manière à délivrer un signal impulsionnel d'adresse de rangée décodée afin de sélectionner le bloc approprié desdits blocs de mémoire (940-1 à 940-4).

12. Système selon l'une quelconque des revendications 8 à 11, caractérisé en ce que lesdits seconds éléments de programme sont appropriés pour faire en sorte qu'aucun autre bit d'adresse d'accès à la mémoire ne soit délivré par ladite unité de traitement (41) lorsque ledit accès à l'antémémoire conduit à une disponibilité d'antémémoire.

13. Système selon l'une quelconque des revendications 8 à 12, caractérisé en ce que lesdits seconds éléments de programme comprennent des troisièmes éléments de commande destinés à délivrer une pluralité de jeux de bits d'adresse de manière successive.

14. Système selon l'une quelconque des revendications 8 à 12, caractérisé en ce que lesdits seconds éléments de programme comprennent des quatrièmes éléments de commande destinés à assurer l'accès à ladite mémoire principale (940) comme pour une mémoire en mode page.
